# EUROPÄISCHE PATENTANMELDUNG

(11) **EP 2 712 285 A1**
(43) Veröffentlichungstag der Anmeldung: **26.03.2014**
(21) Anmeldenummer: 13185531.4
(22) Anmeldetag: 23.09.2013
(51) Int. Cl.: H05K 5/02, H02K 5/26, F16K 31/04, F24F 13/14

(54) **Stellantrieb**

(30) Priorität: 24.09.2012 CH 17212012
(71) Anmelder: Fr. Sauter AG, 4016 Basel (CH)
(72) Erfinder: Niedbalski, Bruno, 4057 Basel (CH)
(74) Vertreter: Bohest AG

(57) **Zusammenfassung**

Ein Stellantrieb umfasst ein Antriebsgehäuse (1) und einen Montagebügel (4) zur Befestigung des Antriebsgehäuses (1) an einem Supportteil. Der Montagebügel (4) weist einen Verbindungsteil (5) und das Antriebsgehäuse (1) Haltemittel (6) für den Verbindungsteil (5) auf, über die der Montagebügel (4) lösbar mit dem Antriebsgehäuse (1) verbindbar ist. Die Haltemittel weisen ein zwischen einer Offenstellung und einer Sperrstellung verschiebbares Riegelelement (6) auf, welches in seiner Sperrstellung in Eingriff mit dem Verbindungsteil (5) des Montagebügels (4) steht und dadurch den Montagebügel (4) am Antriebsgehäuse (1) festhält und welches in seiner Offenstellung ausser Eingriff mit dem Verbindungsteil (5) des Montagebügels (4) steht, so dass der Montagebügel (4) vom Antriebsgehäuse (1) lösbar ist.

## Beschreibung

Die vorliegende Erfindung betrifft einen Stellantrieb gemäss dem Oberbegriff des unabhängigen Patentanspruchs 1.

Stellantriebe werden beispielsweise in der Heizungs-, Lüftungs- und Klimatechnik zur Betätigung von Luft-, Absperr- und Jalousienklappen verwendet. Hierzu weisen sie normalerweise eine drehbare Kupplungsbuchse auf, mit der eine Antriebswelle der Luft-, Absperr- oder Jalousienklappe und damit die Klappe selbst gedreht werden kann. Die Kupplungsbuchse ist zusammen mit einem Motor zu deren Antrieb in einem Antriebsgehäuse angeordnet, das an einem Supportteil, z.B. einem Lüftungskanal, befestigt ist.

Da das Supportteil rohrförmig sein kann, aber auch eine ebene Befestigungsfläche aufweisen kann, wird bei einem bekannten Stellantrieb dieser Art für die Befestigung ein Montagebügel verwendet, der durch Verbiegen an das Supportteil anpassbar und an diesem befestigbar, typischerweise anschraubbar, ist. Der Montagebügel weist einen abstehenden Bolzen mit zylindrischem Kopf auf, welcher als Verbindungsteil zum Antriebsgehäuse des Stellantriebs dient. Das Antriebsgehäuse ist mit einem Aufnahmeteil versehen, der den Bolzen mit Kopf nach seitlichem Einführen aufnimmt. Ein Nachteil dieser Verbindungsart zwischen Antriebsgehäuse und Montagebügel besteht darin, dass das Antriebsgehäuse nur durch eine zusätzliche seitliche Bewegung senkrecht zur Montagerichtung mit dem Montagebügel verbindbar und wieder von diesem lösbar ist.

In der CH 695 385 A5 sind andere Varianten eines gattungsgemässen Stellantriebs mit lösbarem Montagebügel beschrieben. Der Montagebügel weist wieder einen abstehenden Verbindungsteil auf, an den das Antriebsgehäuse über einen den Verbindungsteil aufnehmenden Aufnahmeteil koppelbar ist. Der Verbindungsteil weist Greifelemente auf, die bei an den Verbindungsteil gekoppeltem Aufnahmeteil in Nuten des Aufnahmeteils greifen bzw. von elastisch gelagerten Kugeln hintergriffen werden. Der Verbindungsteil ist senkrecht zur Halterichtung seitlich in den Aufnahmeteil einführbar. Er ist auch in der zur Halterichtung entgegengesetzten Richtung in den Aufnahmeteil einführbar, wobei bei einem derartigen Einführen des Verbindungsteils in den Aufnahmeteil die Greifelemente in den Nuten bzw. die elastisch gelagerten Kugeln hinter den Greifelementen einschnappen. Der Verbindungsteil kann ausserdem ein Stabilisierungselement umfassen, das den Aufnahmeteil senkrecht zur Halterichtung seitlich stabilisiert. Ein Nachteil dieses bekannten Stellantriebs ist darin zu sehen, dass für die Befestigung des Antriebsgehäuses am Montagebügel ein relativ grosser Kraftaufwand und eine relativ grosse Bautiefe im Antriebsgehäuse erforderlich sind.

Angesichts der Nachteile der bisher bekannten Stellantriebe liegt der Erfindung die Aufgabe zugrunde, einen Stellantrieb der gattungsgemässen Art zu schaffen, bei dem das Antriebsgehäuse des Stellantriebs mit dem Montagebügel mit einfachsten konstruktiven Mitteln und ohne grossen Kraftaufwand zuverlässig lösbar verbunden werden kann, wobei die erforderliche Bautiefe für die Verbindung von Antriebsgehäuse und Montagebügel möglichst gering sein soll.

Diese Aufgabe wird durch den erfindungsgemässen Stellantrieb gelöst, wie er im unabhängigen Patentanspruch 1 definiert ist. Bevorzugte Ausführungsvarianten ergeben sich aus den abhängigen Patentansprüchen.

Das Wesen der Erfindung besteht im Folgenden: Ein Stellantrieb umfasst ein Antriebsgehäuse und einen Montagebügel zur Befestigung des Antriebsgehäuses an einem Supportteil. Der Montagebügel weist einen Verbindungsteil und das Antriebsgehäuse Haltemittel für den Verbindungsteil auf, über die der Montagebügel lösbar mit dem Antriebsgehäuse verbindbar ist. Die Haltemittel weisen ein zwischen einer Offenstellung und einer Sperrstellung verschiebbares Riegelelement mit einer Riegelzunge auf, welche in der Sperrstellung des Riegelelements in Eingriff mit dem Verbindungsteil des Montagebügels steht und dadurch den Montagebügel am Antriebsgehäuse festhält und welche in der Offenstellung des Riegelelements ausser Eingriff mit dem Verbindungsteil des Montagebügels steht, so dass der Montagebügel vom Antriebsgehäuse lösbar ist.

Durch die Ausbildung der Haltemittel als verschiebbares Riegelelement mit einer Riegelzunge ist für die Verbindung von Antriebsgehäuse und Montagebügel nur eine geringe Bautiefe erforderlich. Das Verbinden von Antriebsgehäuse und Montagebügel kann mit relativ kleinem Kraftaufwand erfolgen, wobei die Verbindung danach senkrecht zur Riegelverschieberichtung trotzdem relativ hohen Kräften standhalten kann. Nach Zurückschieben des Riegelelements in seine Offenstellung kann das Antriebsgehäuse wieder ohne grossen Kraftaufwand vom Montagebügel gelöst werden, und zwar ohne Querverschieben des Antriebsgehäuses und ohne Lösen des Montagebügels vom Supportteil.

Zweckmässigerweise steht der Verbindungsteil vom Rest des Montagebügels ab und weist das Antriebsgehäuse eine Ausnehmung (Vertiefung oder Öffnung) zur Aufnahme des Verbindungsteils des Montagebügels auf. Dadurch kann der Rest des Montagebügels flach am Antriebsgehäuse anliegen.

Vorzugsweise ist der Montagebügel mit einer Montagewand des Antriebsgehäuses verbindbar, die mindestens einen Führungsschlitz aufweist, in dem das Riegelelement verschiebbar geführt ist. Dies ist konstruktiv relativ einfach und platzsparend.

Gemäss einer besonders vorteilhaften Ausführungsvariante weist das Riegelelement zwei seitliche Gleitleisten auf, zwischen denen die Riegelzunge angeordnet ist. Eine solche Ausbildung erlaubt die Trennung zwischen Führungsfunktion und Riegelfunktion des Riegelelements.

Vorzugsweise sind dabei die beiden Gleitleisten in einer Ebene angeordnet und ist die Riegelzunge in einer gegenüber den beiden Gleitleisten parallel versetzten Ebene angeordnet. Durch eine solche Ausbildung wird die erforderliche Bautiefe weiter verringert.

Mit Vorteil sind in der Montagewand federnde Rastmittel zur lösbaren Fixierung des Riegelelements in der Sperrstellung und/oder der Offenstellung angeordnet. Dadurch wird verhindert, dass sich die Verbindung zwischen Antriebsgehäuse und Montagebügel unbeabsichtigt lösen kann bzw. das Riegelement unbeabsichtigt in die Sperrstellung rutscht oder sich vom Antriebsgehäuse löst.

Vorzugsweise weisen dabei die Rastmittel in der Montagewand im Wesentlichen senkrecht zu dieser federnd gelagerte Rastelemente auf, welche mit im Riegelelement vorhandenen Rastöffnungen zusammenarbeiten. Insbesondere können dabei die Rastelemente an an der Montagewand vorgesehenen Federzungen angeordnet sein. Diese Ausbildung der Rastmittel ist konstruktiv besonders einfach und zweckmässig.

Vorzugsweise ist der Verbindungsteil des Montagebügels durch einen Verriegelungsbügel oder mindestens ein Hakenelement oder durch eine Ausbuchtung des Montagebügels gebildet. Dies ist konstruktiv relativ einfach realisierbar.

Ferner ist es vorteilhaft, wenn das Riegelelement und der Verbindungsteil des Montagebügels so ausgebildet sind, dass der Montagebügel im am Antriebsgehäuse befestigten Zustand um eine zur Verschieberichtung des Riegelelements senkrechte Achse um mindestens 5°, vorzugsweise mindesten 10°, schwenkbar ist. Dies erlaubt eine einfache Anpassung an unterschiedlichste Montageverhältnisse.

Im Folgenden wird der erfindungsgemässe Stellantrieb anhand von in den Zeichnungen dargestellten Ausführungsbeispielen detaillierter beschrieben. Es zeigen:
- Fig. 1-2 -: zwei Perspektivansichten eines Ausführungsbeispiels des erfindungsgemässen Stellantriebs mit losem bzw. befestigtem Montagebügel;
- Fig. 3-4 -: zwei Detailansichten eines Montagebügels und eines Riegelelements des Stellantriebs;
- Fig. 5 -: einen Detailschnitt nach der Linie V-V der Fig. 2;
- Fig. 6-8b -: vier Skizzen zur Erläuterung von Detailvarianten des Stellantriebs;
- Fig. 9 -: eine Draufsicht auf eine Montagewand des Antriebsgehäuses des Stellantriebs mit befestigtem Montagebügel und
- Fig. 10 -: eine Perspektivansicht eines an einem rohrförmigen Supportteil befestigten Stellantriebs.

Für die nachstehende Beschreibung gilt die folgende Festlegung: Sind in einer Figur zum Zweck zeichnerischer Eindeutigkeit Bezugszeichen angegeben, aber im unmittelbar zugehörigen Beschreibungsteil nicht erwähnt, so wird auf deren Erläuterung in vorangehenden oder nachfolgenden Beschreibungsteilen verwiesen. Umgekehrt sind zur Vermeidung zeichnerischer Überladung für das unmittelbare Verständnis weniger relevante Bezugszeichen nicht in allen Figuren eingetragen. Hierzu wird auf die jeweils übrigen Figuren verwiesen.

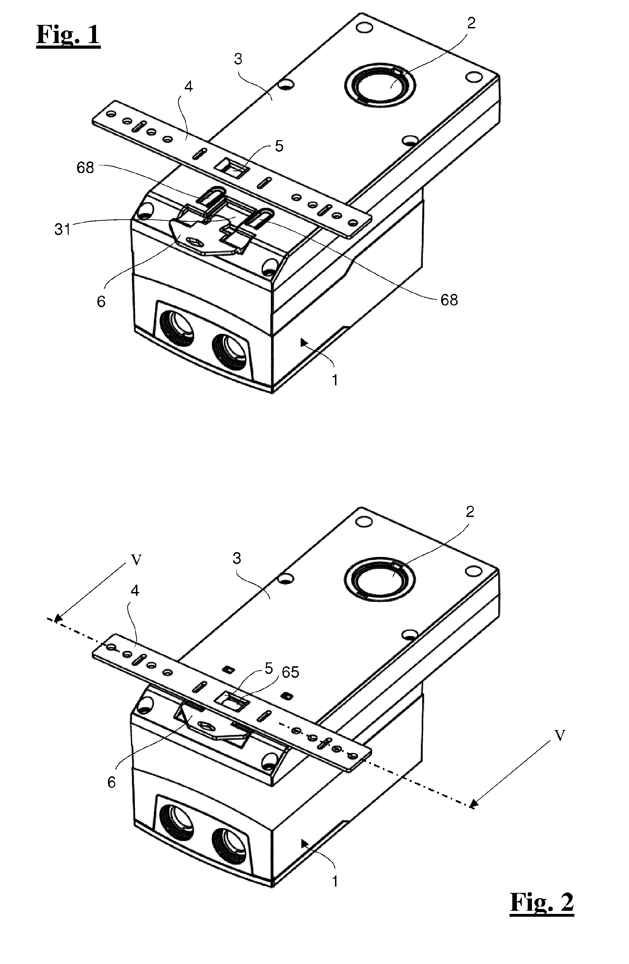

Die Figuren 1 und 2 zeigen erfindungswesentliche Komponenten des Stellantriebs gemäss der vorliegenden Erfindung. Der Stellantrieb umfasst ein Antriebsgehäuse 1, in welchem eine motorisch angetriebene Kupplungsbuchse 2 für eine nicht dargestellte, anzutreibende Welle gelagert ist. Ein Antriebsmotor mit Getriebe und die zur Steuerung des Antriebsmotors erforderlichen Teile sind ebenfalls im Antriebsgehäuse 1 untergebracht, der Übersichtlichkeit halber aber nicht dargestellt.

Das Antriebsgehäuse 1 weist eine im Wesentlichen flache Montagewand 3 auf, die im praktischen Einsatz dem Supportteil, an dem der Stellantrieb befestigt werden soll, zugewandt ist. Der Supportteil ist in den Figuren 1 und 2 nicht dargestellt.

Zur Befestigung des Stellantriebs an einem Supportteil ist ein Montagebügel 4 vorgesehen, der einerseits in noch näher zu erläuternder Weise lösbar mit dem Antriebsgehäuse 1 des Stellantriebs verbunden ist und anderseits am Supportteil befestigt werden kann, typischerweise etwa mittels Schrauben. Der Montagebügel 4 besitzt im Wesentlichen die Gestalt eines flachen Lochbands.

Der Montagebügel 4 ist etwa in der Mitte seiner Längserstreckung mit einem vom flachen Rest abstehenden Verbindungsteil 5 versehen, der mit an der Montagewand 3 des Antriebsgehäuses 1 vorgesehenen Haltemitteln 6 zusammenwirkt, um den Montagebügel 4 und das Antriebsgehäuse 1 lösbar miteinander zu verbinden.

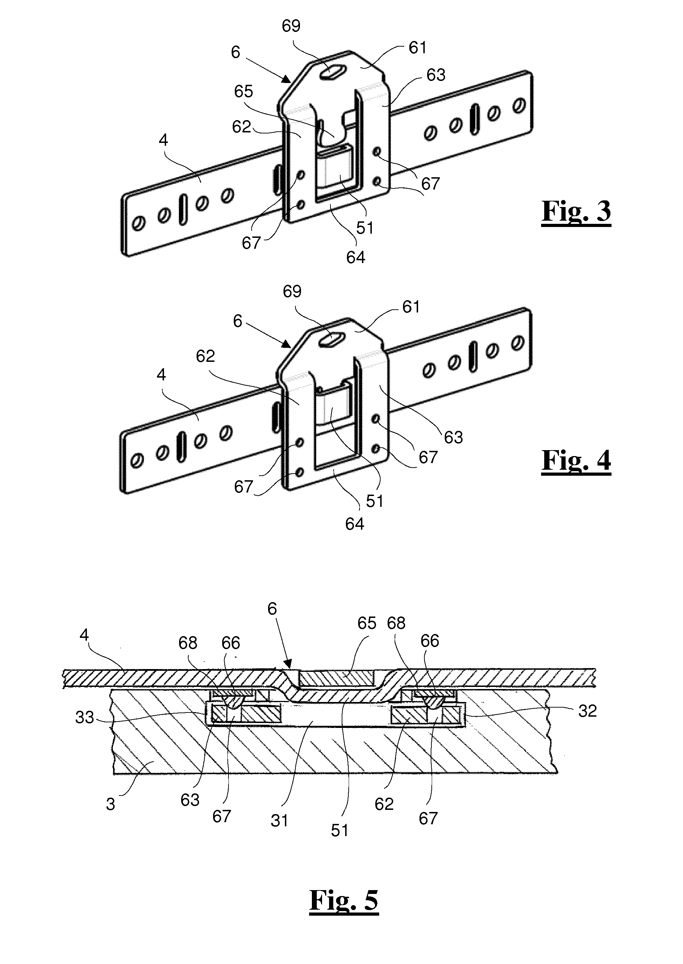

Die Erfindung betrifft vor allem die konkrete Ausbildung des Verbindungsteils 5 des Montagebügels 4 und der Haltemittel 6 an der Montagewand 3 des Antriebsgehäuses 1, worauf im Folgenden in Verbindung mit den Figuren 3-5 im Detail eingegangen wird.

Die Haltemittel 6 sind als einstückiges Riegelelement ausgebildet. Dieses umfasst einen ebenen Kopfteil 61, zwei seitliche Gleitleisten 62 und 63, eine Querstrebe 64 und eine Riegelzunge 65, die sich zwischen die beiden Gleitleisten 62 und 63 erstreckt. Der Kopfteil 61 und die Riegelzunge 65 liegen in einer ersten Ebene. Die beiden Gleitleisten 62 und 63 und die sie verbindende Querstrebe 64 liegen in einer zur ersten Ebene parallelen zweiten Ebene. Der Kopfteil 61 ist mit einem Befestigungsloch 69 versehen.

In der Montagewand 3 des Antriebsgehäuses 1 ist eine als Vertiefung oder Öffnung ausgebildete Ausnehmung 31 angeordnet. Zu beiden Seiten der Ausnehmung 31 sind Führungsschlitze 32 und 33 vorgesehen, in denen das Riegelelement 6 mit je einer seiner beiden Gleitleisten 62 und 63 verschiebbar gelagert ist. Es kann dabei von einer Offenstellung (Fig. 1) in Richtung auf die Kupplungsbuchse 2 zu in eine Sperrstellung (Fig. 2) und zurück verschoben werden. Die Führungsschlitze 32 und 33 sind am besten im Detailschnitt der Fig. 5 zu erkennen.

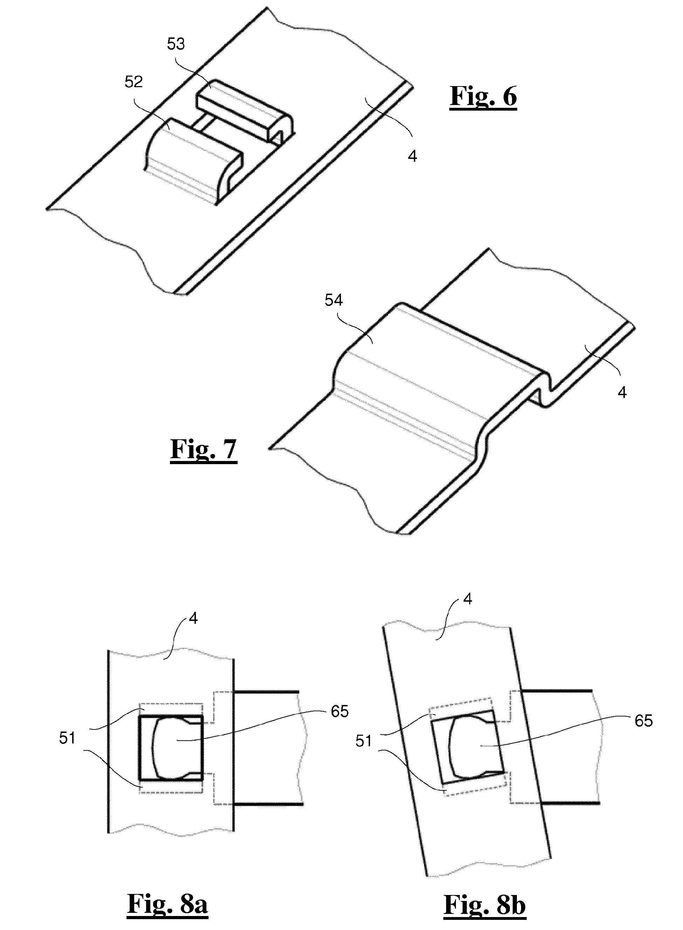

Der Verbindungsteil 5 des Montagebügels 4 ist in einer Variante als einstückig angeformter Verriegelungsbügel 51 ausgebildet, wie dies am besten aus Fig. 3 erkennbar ist. Der Verriegelungsbügel 51 bildet zwischen sich und dem Rest des Montagebügels 4 einen flachen Schlitz, dessen lichte Weite nur geringfügig grösser als die Querschnittsabmessungen der Riegelzunge 65 des Riegelelements 6 ist. In einer anderen Variante umfasst der Verbindungsteil zwei aus dem Montagebügel 4 hervorstehende Hakenelemente 52 und 53 (Fig. 6). In einer weiteren Variante ist der Verbindungsteil durch eine Ausbuchtung 54 des Montagebügels 4 gebildet (Fig. 7).

Zur gegenseitigen Fixierung von Antriebsgehäuse 1 und Montagebügel 4 wird der letztere bei in Offenstellung befindlichem Riegelelement 6 so auf die Montagewand 3 aufgesetzt, dass sein abstehender Verbindungsteil 5, also entweder der Verriegelungsbügel 51 oder die beiden Hakenelemente 52 und 53 oder die Ausbuchtung 54, in der Ausnehmung 31 der Montagewand 3 zu liegen kommt. Dann wird das Riegelelement 6 in seine Sperrstellung verschoben, wobei die Riegelzunge 65 dann den Verriegelungsbügel 51 bzw. die Hakenelemente 52 und 53 bzw. die Ausbuchtung 54 hintergreift und dadurch den Montagebügel 4 an der Montagewand 3 und damit am Antriebsgehäuse 1 fixiert (Fig. 2 und Fig. 4). Zum Lösen des Antriebsgehäuses 1 vom Montagebügel 4 wird das Riegelelement 6 in Richtung aus dem Antriebsgehäuse heraus in seine Offenstellung verschoben, wobei die Riegelzunge 65 ausser Eingriff mit dem Verbindungsteil 5 kommt (Fig. 3). Danach kann das Antriebsgehäuse 1 vom Montagebügel 4 ohne grossen Kraftaufwand abgenommen werden.

Damit sich das Riegelelement 6 nicht unbeabsichtigt verschieben kann, ist es zweckmässigerweise durch in der Montagewand vorgesehene federnde Rastmittel gesichert, welche das Riegelelement 6 in seiner Sperrstellung und in seiner Offenstellung lösbar festhalten, wobei die Fixierung in der Offenstellung vor allem verhindern soll, dass das Riegelelement 6 aus der Montagewand 3 herausfallen kann. Die Rastmittel umfassen Rastelemente 66, welche in der Montagewand 3 im Wesentlichen senkrecht zu dieser federnd gelagert sind und mit in den seitlichen Gleitleisten 62 und 63 des Riegelelements 6 vorgesehenen Rastöffnungen 67 zusammenwirken. Die Rastelemente 66 sind an den freien Enden von zwei Federzungen 68 angeordnet, welche zu beiden Seiten der Ausnehmung 31 der Montagewand 3 an bzw. in der Montagewand 3 vorgesehen sind. Vorzugsweise sind die Federzungen 68 einstückig mit der Montagewand 3 ausgebildet. Die Federzungen 68, die Rastelemente 67 und die Rastöffnungen 67 sind in Fig. 5 deutlich zu sehen.

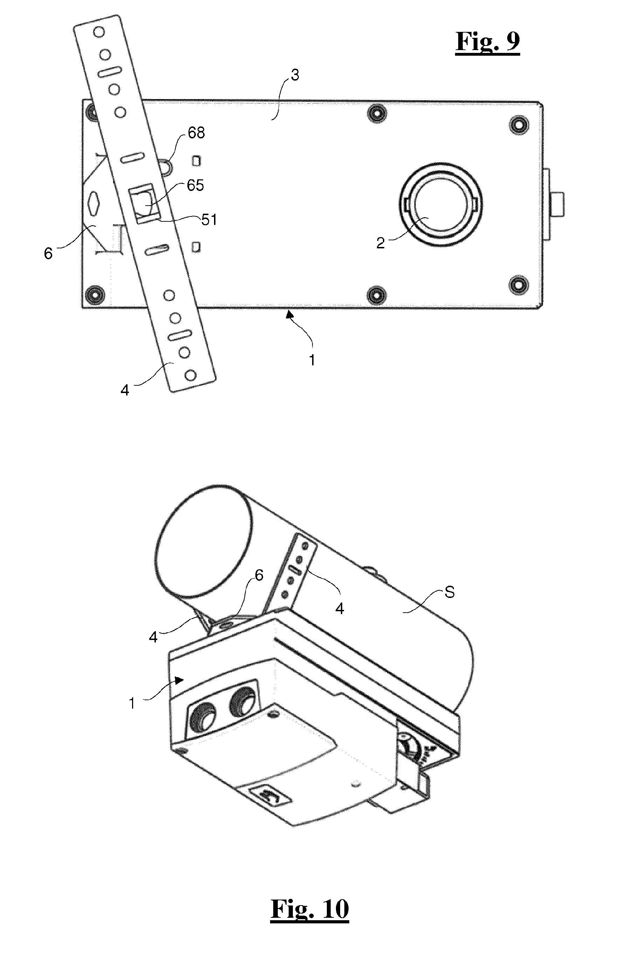

Die Riegelzunge 65 des Riegelelements 6 einerseits und der Verriegelungsbügel 51 bzw. die Hakenelemente 52 und 53 bzw. die Ausbuchtung 54 des Montagebügels 4 sind vorzugsweise formlich so aufeinander abgestimmt, dass die Riegelzunge 65 mit einem gewissen Spiel im Verriegelungsbügel 51 bzw. zwischen den Hakenelementen 52 und 53 bzw. in der Ausbuchtung 54 des Montagebügels 4 sitzt. Dadurch kann der Montagebügel 4 relativ zum Antriebsgehäuse 1 um eine zur Montagewand 3 senkrechte Achse bzw. um eine zur Verschieberichtung des Riegelelements 6 senkrechte Achse um mindestens 5°, vorzugsweise mindesten 10°, verschwenkt werden, was eine Anpassung an spezielle Montageerfordernisse ermöglicht. Die Figuren 8a und 8b sowie 9 verdeutlichen dies.

Der Montagebügel 4 besteht zweckmässigerweise aus einem biegsamen Material, insbesondere Metall, so dass er an die Form des jeweiligen Supportteils angepasst werden kann. Die Fig. 10 zeigt einen an einem rohrförmigen Supportteil S befestigten Stellantrieb mit einem abgewinkelten Montagebügel 4.

## Patentansprüche

1. Stellantrieb mit einem Antriebsgehäuse (1) und einem Montagebügel (4) zur Befestigung des Antriebsgehäuses (1) an einem Supportteil (S), wobei der Montagebügel (4) einen Verbindungsteil (5) und das Antriebsgehäuse (1) Haltemittel (6) für den Verbindungsteil (5) aufweist, über die der Montagebügel (4) lösbar mit dem Antriebsgehäuse (1) verbindbar ist, **dadurch gekennzeichnet, dass** die Haltemittel ein zwischen einer Offenstellung und einer Sperrstellung verschiebbares Riegelelement (6) mit einer Riegelzunge (65) aufweisen, welche in der Sperrstellung des Riegelelements (6) in Eingriff mit dem Verbindungsteil (5) des Montagebügels (4) steht und dadurch den Montagebügel (4) am Antriebsgehäuse (1) festhält und welche in der Offenstellung des Riegelelements (6) ausser Eingriff mit dem Verbindungsteil (5) des Montagebügels (4) steht, so dass der Montagebügel (4) vom Antriebsgehäuse (1) lösbar ist.

2. Stellantrieb nach Anspruch 1, **dadurch gekennzeichnet, dass** der Verbindungsteil (5) vom Rest des Montagebügels (4) absteht und das Antriebsgehäuse (1) eine Ausnehmung (31) zur Aufnahme des Verbindungsteils (5) aufweist.

3. Stellantrieb nach einem der vorangehenden Ansprüche, **dadurch gekennzeichnet, dass** der Montagebügel (4) mit einer Montagewand (3) des Antriebsgehäuses (1) verbindbar ist, die mindestens einen Führungsschlitz (32, 33) aufweist, in dem das Riegelelement (6) verschiebbar geführt ist.

4. Stellantrieb nach einem der vorangehenden Ansprüche, **dadurch gekennzeichnet, dass** das Riegelelement (6) zwei seitliche Gleitleisten (62, 63) aufweist, zwischen denen die Riegelzunge (65) angeordnet ist.

5. Stellantrieb nach Anspruch 4, **dadurch gekennzeichnet, dass** die beiden Gleitleisten (62, 63) in einer Ebene angeordnet sind und dass die Riegelzunge (65) in einer gegenüber den beiden Gleitleisten (62, 63) parallel versetzten Ebene angeordnet ist.

6. Stellantrieb nach einem der Ansprüche 3 bis 5, **dadurch gekennzeichnet, dass** in der Montagewand (3) federnde Rastmittel (66) zur lösbaren Fixierung des Riegelelements (6) in der Sperrstellung und/oder der Offenstellung angeordnet sind.

7. Stellantrieb nach Anspruch 6, **dadurch gekennzeichnet, dass** die Rastmittel in der Montagewand (3) im Wesentlichen senkrecht zu dieser federnd gelagerte Rastelemente (66) aufweisen, welche mit im Riegelelement (6) vorhandenen Rastöffnungen (67) zusammenwirken.

8. Stellantrieb nach Anspruch 7, **dadurch gekennzeichnet, dass** die Rastelemente (66) an an der Montagewand (3) angeordneten Federzungen (68) angeordnet sind.

9. Stellantrieb nach einem der vorangehenden Ansprüche, **dadurch gekennzeichnet, dass** der Verbindungsteil (5) des Montagebügels (4) durch einen Verriegelungsbügel (51) oder mindestens ein Hakenelement (52, 53) oder durch eine Ausbuchtung (54) des Montagebügels (4) gebildet ist.

10. Stellantrieb nach einem der vorangehenden Ansprüche, **dadurch gekennzeichnet, dass** das Riegelelement (6) und der Verbindungsteil (5) des Montagebügels (4) so ausgebildet sind, dass der Montagebügel (4) im am Antriebsgehäuse (1) befestigten Zustand um eine zur Verschieberichtung des Riegelelements (6) senkrechte Achse um mindestens 5°, vorzugsweise mindesten 10°, schwenkbar ist.
